(19) Europäisches Patentamt
European Patent Office
Office européen des brevets

(11) Publication number: **0 370 464 A2**

(12) **EUROPEAN PATENT APPLICATION**

(21) Application number: 89121522.0

(22) Date of filing: 21.11.89

(51) Int. Cl.5: C08L 101/10, C08L 63/00, C08K 5/54

(30) Priority: 21.11.88 JP 293927/88

(43) Date of publication of application: 30.05.90 Bulletin 90/22

(84) Designated Contracting States: BE CH DE ES FR GB IT LI NL SE

(71) Applicant: Kanegafuchi Chemical Industry Co., Ltd.
2-4 Nakanoshima 3-chome
Kita-ku Osaka-shi Osaka-fu(JP)

(72) Inventor: Homma, Michihide
Kouun-ryo 2-63 Okihama-cho Takasago-cho
Takasago-shi Hyogo-ken(JP)

Inventor: Yoshihara, Atsuko
8-1-21 Shinryodai Tarumi-ku
Kobe-shi Hyogo-ken(JP)
Inventor: Wakabayashi, Hiroshi
2-8-B-102 Maikodai Tarumi-ku
Kobe-shi Hyogo-ken(JP)
Inventor: Isayama, Katsuhiko
4-8-7 Tsukushigaoka Kita-ku
Kobe-shi Hyogo-ken(JP)

(74) Representative: Hansen, Bernd, Dr.rer.nat. et al
Hoffmann, Eitle & Partner Patentanwälte
Arabellastrasse 4 Postfach 81 04 20
D-8000 München 81(DE)

(54) **Curable resin composition.**

(57) A curable resin composition comprising

(A) 100 parts by weight of an organic rubbery polymer having a cross-linkable group of the formula:

$$-\overset{\displaystyle R^1}{\overset{|}{Si}}(OR^2)_2$$

wherein $R^1$ and $R^2$ are the same or different and each a substituted or unsubstituted monovalent hydrocarbon group having 1 to 20 carbon atoms,

(B) 70 to 500 parts by weight of an epoxy resin,

(C) 0.1 to 20 parts by weight of a silanol condensation catalyst per 100 parts by weight of the organic rubbery polymer (A),

(D) 0.1 to 300 parts by weight of a curing agent for the epoxy resin per 100 parts by weight of the epoxy resin (B), and

(E) a silicon-containing compound having a cross-linkable group of the formula:

$$-\overset{\displaystyle R^1}{\overset{|}{Si}}(OR^2)_2$$

wherein $R^1$ and $R^2$ are the same as defined and a functional group reactive with an epoxy group, wherein a weight ratio of the total weight of the organic rubbery polymer (A) and the epoxy resin (B) to the weight of

EP 0 370 464 A2

the silicon-containing compound (E) is from 100:0.1 to 100:20, which provides a cured product with high modulus.

# CURABLE RESIN COMPOSITION

## BACKGROUND OF THE INVENTION

### Field of the Invention

The present invention relates to a curable resin composition, and more particularly, the present invention relates to a curable resin composition which provides a cured product having improved flexibility, impact resistance, toughness and strength and is suitable as an adhesive.

### Description of the Related Art

Epoxy resins find various applications such as molding materials, adhesives, coatings, plywoods, laminates and the like. Common problems found in these applications are brittleness of cured products of the epoxy resins and low peeling strength in case where the epoxy resins are sued as adhesives.

An organic rubbery polymer which has at least one silicon-containing group to the silicon atom of which a hydrolyzable group is bonded (hereinafter referred to as a "silicon-containing reactive group") is cured even at room temperature to give a rubbery elastomer. However, the cured product of such rubbery polymer has small strength, which prevents its wide application.

U.S. Patent No. 4,657,986, EP-A-0 186 191 and Japanese Patent Kokai Publication No. 268720/1986 disclose a curable resin composition comprising the rubbery (elastomeric) polymer having the silicon-containing reactive group, an epoxy resin and a silicon-containing compound having the silicon-containing reactive group and a functional group reactive with the epoxy group and that such composition can overcome the defects of the epoxy resin and the organic rubbery polymer having the silicon-containing reactive group.

Although the proposed curable resin composition can improve the brittleness of the cured product of the epoxy resin and strength of the cured material of the organic rubbery polymer having the silicon-containing reactive group, the cured product from such composition does not necessarily have good balance between shear strength and peeling strength. Further, it is difficult to obtain the cured product having large modulus.

## SUMMARY OF THE INVENTION

One object of the present invention is to provide a curable resin composition which can provide a cured product having good balance between shear strength and peeling strength.

Another object of the present invention is to provide a curable resin composition which can provide a cured product having large modulus.

Accordingly, the present invention provides a curable resin composition comprising

(A) 100 parts by weight of an organic rubbery polymer having a cross-linkable group of the formula:

$$-\overset{\displaystyle R^1}{\underset{}{\overset{|}{Si}}}(OR^2)_2$$

wherein $R^1$ and $R^2$ are the same or different and each a substituted or unsubstituted monovalent hydrocarbon group having 1 to 20 carbon atoms,

(B) 70 to 500 parts by weight of an epoxy resin,

(C) 0.1 to 20 parts by weight of a silanol condensation catalyst per 100 parts by weight of the organic rubbery polymer (A),

(D) 0.1 to 300 parts by weight of a curing agent for the epoxy resin per 100 parts by weight of the epoxy resin (B), and

(E) a silicon-containing compound having a cross-linkable group of the formula:

$$-\overset{R^1}{\overset{|}{Si}}(OR^2)_2$$

wherein $R^1$ and $R^2$ are the same as defined and a functional group reactive with an epoxy group, wherein a weight ratio of the total weight of the organic rubbery polymer (A) and the epoxy resin (B) to the weight of the silicon-containing compound (E) is from 100:0.1 to 100:20.

## DETAILED DESCRIPTION OF THE INVENTION

Examples of a backbone chain which constitutes the organic rubbery polymer (A) having the cross linking group of the formula:

$$-\overset{R^1}{\overset{|}{Si}}(OR^2)_2$$

wherein $R^1$ and $R^2$ are the same as defined above are polyethers prepared by ring opening polymerization of cyclic ethers (e.g. propylene oxide, ethylene oxide and tetrahydrofuran); polyesters prepared by polycondensation of a dibasic acid (e.g. adipic acid) and glycol or ring opening polymerization of lactones; ethylene-propylene copolymers; isobutylene base polymers such as polyisobutylene and copolymers of isobutylene with other monomers (e.g. isoprene); polychloroprene; isoprene base polymers such as polyisoprene and copolymers of isoprene with other monomers (e.g. butadiene, styrene, acrylonitrile, etc.); butadiene base polymers such as polybutadiene and copolymers of butadiene with other monomers (e.g. styrene, acrylonitrile, etc.); polyolefins prepared by hydrogenating polyisoprene, polybutadiene or isoprene/butadiene copolymers; polyacrylates prepared by radical polymerization of acrylate monomers (e.g. ethyl acrylate, butyl acrylate, etc.) or copolymers of such acrylate with other monomers (e.g. vinyl acetate, acrylonitrile, styrene, ethylene, etc.); graft copolymers prepared by polymerizing a vinyl monomer in the presence of the organic rubbery polymer to be used in the present invention, and the like. Preferably, the polymer has a glass transition temperature $T_g$ of not higher than 0 °C. Among them, the polyethers comprising the repeating units of the formula: $-R^3-O-$ in which $R^3$ is a divalent alkylene group having 2 to 4 carbon atoms (e.g. polypropylene oxide), the acrylic ester polymers and the polyesters are preferred. More particularly, the polyethers comprising the repeating units of the formula: $-R^3-O-$ in which $R^3$ is the same as defined above such as polypropylene oxide are preferred.

In the silicon-containing reactive group of the formula:

$$-\overset{R^1}{\overset{|}{Si}}(OR^2)_2$$

wherein $R^1$ and $R^2$ are the same as defined above (hereinafter referred to as "divalent alkoxysilyl group"), preferred examples of the $R^1$ substituent are substituted or unsubstituted hydrocarbon groups such as a methyl group, a chloromethyl group, a fluoromethyl group, an ethyl group, a phenyl group and a vinyl group. In view of easy production, the methyl group is preferred. Preferred examples of the $R^2$ substituent are hydrocarbon groups which may have an ether linkage such as a methyl group, an ethyl group, a propyl group, a phenyl group, a methoxyethyl group and an ethoxyethyl group. Among them, the methyl group is preferred. The organic rubbery polymer contains at least one, preferably 1.2 to 6 divalent alkoxysilyl groups in a molecule on the average.

The organic rubbery polymers having the divalent alkoxysilyl group may be prepared by following manners:

(1) Copolymerizing a monomer having a copolymerizable unsaturated bond and the divalent alkoxysilyl group (e.g. vinylmethyldialkoxysilane, methacryloyloxypropylmethyldialkoxysilane, etc.) with a polymerizable monomer (e.g. ethylene, propylene, isobutylene, chloroprene, isoprene, butadiene, acrylate, etc.); or copolymerizing a monomer having a copolymerizable epoxy group and the divalent alkoxysilyl group (e.g. γ-glycidoxypropylmethyldimethoxysilane) with propylene oxide or ethylene oxide.

By this manner, the divalent alkoxysilyl group is introduced in the side chain of the organic rubbery polymer.

(2) Polymerizing a radically polymerizable monomer in the presence of a mercapto or disulfide type chain transfer agent having the divalent alkoxysilyl group (e.g. mercaptopropylmethyldialkoxysilane).

(3) Polymerizing a radically polymerizable monomer by the use of an azo or peroxide type polymerization initiator having the divalent alkoxysilyl group (e.g. azobis-2-(6-methyldiethoxysilyl-2-cyanohexane)).

By the manners (2) and (3), the divalent alkoxysilyl group is introduced at the chain end of the polymer molecule.

(4) Reacting a compound having a functional group Y′ and the divalent alkoxysilyl group with a polymer having a functional group Y which is reactive with the functional group Y′ (e.g. a hydroxy group, a carboxy group, a mercapto group, an epoxy group and an isocyanate group) on the side chain and/or at the chain end of the molecule.

Specific examples of the reactions (4) are shown in following Table 1.

Table 1.

| Functional group Y | Functional group Y' | Resulting bond |
|---|---|---|
| -COOH | HO- | -COO- |
| ↑ | $CH_2$-CH-<br>\ /<br>O | -$COOCH_2$CH-<br>\|<br>OH |
| ↑ | $H_2N$- | $COO^-H_3N^+$- or -CONH- |
| ↑ | OCN- | -COOCONH- |
| ↑ | $CH_2$=CHCOO- | -$COOCH_2CH_2$COO- |
| -OH | OCN- | -OCONH- |
| -SH | $CH_2$-CH-<br>\ /<br>O | -$SCH_2$CH-<br>\|<br>OH |
| ↑ | OCN- | -SCONH- |
| ↑ | $CH_2$=CHCOO- | -$SCH_2CH_2$COO- |
| ↑ | $CH_2$=CH- | -$SCH_2CH_2$- |
| ↑ | $ClCH_2$- | -$SCH_2$- |
| -CH-$CH_2$<br>\ /<br>O | HOOC- | -$CHCH_2$OCO-<br>\|<br>OH |
| ↑ | HS- | -$CHCH_2$S-<br>\|<br>OH |
| ↑ | $H_2N$- | -$CHCH_2$NH-<br>\|<br>OH |
| ↑ | HO- | -$CHCH_2$O-<br>\|<br>OH |

Table 1: (continued)

<table>
<tr><th>Functional group Y</th><th>Functional group Y'</th><th>Resulting bond</th></tr>
<tr><td>$-NH_2$</td><td>$CH_2-CH-$<br>\ /<br>O</td><td>$-NHCH_2-CH-$<br>|<br>OH</td></tr>
<tr><td>↑</td><td>OCN-</td><td>-NHCONH-</td></tr>
<tr><td>↑</td><td>HOOC-</td><td>$-\overset{+}{N}H_3O^-CO-$ or -NHCO-</td></tr>
<tr><td>↑</td><td>$ClCH_2-$</td><td>$-\overset{+}{N}H_2CH_2-$<br>|<br>$Cl^-$</td></tr>
<tr><td>↑</td><td>$CH_2=CHCOO-$</td><td>$-NHCH_2CH_2COO-$</td></tr>
<tr><td>$-CONH_2$</td><td>OCN-</td><td>-CONHCONH-</td></tr>
<tr><td>$-CH=CH_2$</td><td>HS-</td><td>$-CH_2CH_2S-$</td></tr>
<tr><td>↑</td><td>$H-Si\equiv$</td><td>$-CH_2CH_2Si\equiv$</td></tr>
<tr><td>-NCO</td><td>HOOC-</td><td>-NHCOOCO-</td></tr>
<tr><td>↑</td><td>HO-</td><td>-NHCOO-</td></tr>
<tr><td>↑</td><td>HS-</td><td>-NHCOS-</td></tr>
<tr><td>↑</td><td>$H_2N-$</td><td>-NHCONH-</td></tr>
<tr><td>-CH--CH-<br>| |<br>O=C C=O<br>\ /<br>O</td><td>HO-</td><td>-CH-CH-<br>| |<br>O=C C=O<br>| |<br>HO O-</td></tr>
<tr><td>↑</td><td>$H_2N-$</td><td>-CH-CH-<br>| |<br>O=C C=O<br>| |<br>HO NH-</td></tr>
</table>

Specific examples of the silicon-containing compound having the functional group Y′ are amino group-containing silanes (e.g. γ(2-aminoethyl)aminopropylmethyldimethyxysilane); mercapto group-containing silanes (e.g. γ-mercaptopropylmethyldimethoxysilane); epoxysilanes (e.g. γ-glycidoxypropylmethyldimethoxysilane and β-(3,4-epoxycyclohexyl)ethylmethyldimethoxysilanes); ethylenically unsaturated group-containing silanes (e.g. vinylmethyldimethoxysilane, γ-methacryloyloxypropylmethyldialkoxysilane and γ-acryloyloxypropylmethyldialkoxysilane); chlorine-containing silanes (e.g. γ-chloropropylmethyldialkoxysilane); isocyanate-containing silanes (e.g. γ-isocyanatepropylmethyldialkoxysilane); and hydrosilanes (e.g. methyldimethoxysilane and methyldiethoxysilane).

Among the combination of the polymer having the functional group Y and the compound having the functional group Y′, (i) a combination of the polymer having the isocyanate group and the amino or mercapto group-containing silane and (ii) a combination of the polymer having the ethylenically unsaturated group and the hydroxysilane are preferable. Among the combination (ii), a combination of polypropylene oxide having an allylether group at the chain end and the hydrosilane is particularly preferable. In the combination (ii), the silyl group can be introduced in the polymer through a hydrosilylation reaction in the presence of a platinum catalyst.

The molecular weight of the organic rubbery polymer (A) having the divalent alkoxysilyl group is usually from about 500 to 50,000, preferably from 1,000 to 20,000, since in this molecular weight range, the polymer is in a liquid state and easily handled.

Preferably, the divalent alkoxysilyl group is attached to the chain end of the organic rubbery polymer molecule, because the terminal divalent alkoxysilyl group elongates the chain length between the adjacent cross linking sites in the cured product so that the brittleness of the epoxy resin is more effectively improved.

Preferably examples of the organic rubbery polymer (A) are disclosed in U.S. Patent No. 3,971,751 the disclosure of which is hereby incorporated by reference, Japanese Patent Publication Nos. 36319/1970, 12154/1971 and 32673/1974; and Japanese Patent Kokai Publication Nos. 156599/1975, 73561/1976, 6096/1979, 13767/1979, 13768/1979, 82123/1980, 123620/1980, 125121/1980, 131021/1980, 131022/1980, 135135/1980, 137129/1980, 179210/1982, 191703/1983, 78220/1984, 78221/1984, 78222/1984, 78223/1984 and 168014/1984.

The epoxy resin (B) may be any one of conventionally used ones. Specific examples of the epoxy reins (B) are flame-retardant epoxy resins (e.g. epichlorohydrinbisphenol A type epoxy resin, epichlorohydrin-bisphenol F type epoxy resin and glycidyl ether of tetrabromobisphenol A), novolak type epoxy resins, hydrogenated bisphenol A type epoxy resins, epoxy resins of the type of glycidyl ether of bisphenol A-propyleneoxide adduct, glycidyl p-oxybenzoate ether ester type epoxy resin, m-aminophenol type epoxy resins, diaminodiphenylmethane type epoxy resins, urethane modified epoxy resins, alicyclic epoxy resins, glycidyl ether of polyhydric alcohol (e.g. N,N-diglycidylaniline, N,N-diglydicyl-o-toluidine,triglycidylisocyanurate, polyalkyleneglycol diglycidyl ether and glycerin), hydantoin type epoxy resins, epoxidized unsaturated polymer such as petroleum resin, and the like. Among them, those having two epoxy groups of the formula:

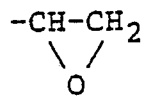

in a molecule are preferable since they are highly reactive during curing and the cured product easily forms a three dimensional network. Most preferable are the bisphenol A type epoxy resins and the novolak type epoxy resins.

The amount of the epoxy resin (B) is from 70 to 500 parts by weight, preferably from 70 to 200 parts by weight per 100 parts by weight of the organic rubbery polymer (A). When the amount of the epoxy resin is less than the above lower limit, shear strength of the cured product is too low. When such amount exceeds the above upper limit, the peeling strength of the cured product is too small.

Specific examples of the silanol condensation catalyst (C) are titanates (e.g. tetrabutyl titanate and tetrapropyl titanate), tin carbonates (e.g. dibutyltin laurate, dibutytin maleate, dibutyltin diacetate, tin octylate and tin naphthenate), a reaction product of dibutyltin oxide and a phthalate, dibutyltin diacetylacetonate, organic aluminum compounds (e.g. aluminum trisacetylacetonate, aluminum trisethylacetoacetate and diisopropoxyaluminum ethylacetoacetonate), chelate compounds (e.g. zirconium tetraacetylacetonate and titanium tetraacetylacetonate), lead octylate, amines (e.g. butylamine, monoethanolamine, triethylenetetramine, guanidine, 2-ethyl-4-methylimidazole and 1,8-diazabicylco[5.4.0]undecene-7 (DBU)) or their salts with carboxylic acids, and other silanol condensation acid or base catalysts.

The silanol condensation catalyst is used in an amount of 0.1 to 20 parts by weight per 100 parts by weight of the organic rubbery polymer (A).

The curing agent (D) for the epoxy resin used according to the present invention may be any one of the conventionally used ones. Specific examples of the curing agent (D) are amines (e.g. triethylenetetramine, tetraethylenepentamine, diethylaminopropylamine, N-aminoethylpiperazine, m-xylylenediamine, m-phenylenediamine, diaminodiphenylmethane, diaminodiphenylsulfone, isophoronediamine and 2,4,6-tris-

(dimethylaminomethyl)phenol); tert.-amine salts; polyamide resins; imidazoles; dicyanediamides; complex compounds of boron trifluoride; carboxylic acid anhydrides (e.g. phthalic anhydride, hexahydrophthalic anhydride, tetrahydrophthalic anhydride, endomethylenetetrahydrophthalic anhydride, dodecyl succinic anhydride, pyromellic anhydride and chlorenic anhydride); alcohols; phenols; and carboxylic acids.

The amount of the curing agent (D) varies with the kinds of the epoxy resin and/or the curing agent. Usually, 0.1 to 300 parts by weight of the curing agent (D) is used per 100 parts by weight of the epoxy resin (B).

The curable resin composition of the present invention contains the silicon-containing compound having the functional group reactive with the epoxy group and the divalent alkoxysilyl group (E) as one of the essential components.

Examples of the functional group reactive with the epoxy group are a primary, secondary or tertiary amino group, a mercapto group, an epoxy group and a carboxyl group. Among them, the primary amino group is preferred. The divalent alkoxysilyl group is represented by the formula:

$$-\overset{R^1}{\overset{|}{Si}}(OR^2)_2$$

wherein $R^1$ and $R^2$ are the same as defined above. The alkoxy group $OR^2$ is preferably the same as that in the organic rubbery polymer (A). More preferably, the alkoxysilyl group is the same as that in the organic rubbery polymer (A).

Specific examples of the silicon-containing compound (E) are amino group-containing silanes (e.g. $\gamma$-aminopropylmethyldimethoxysilane, $\gamma$-aminopropylmethyldiethoxysilane, $\gamma$-aminopropylmethyldi(2-methoxyethoxy)silane, $\gamma$-(2-aminoethyl)aminopropylmethyldimethoxysilane, $\gamma$-(2-aminoethyl)-aminopropylmethyldiethoxysilane, N-$\beta$-(N-vinylbenzylaminoethyl)-$\gamma$-aminopropylmethyldimethoxysilane and $\gamma$-anilinopropylmethyldimethoxysilane); mercapto group-containing silanes (e.g. $\gamma$-mercaptopropylmethyldimethoxysilane and $\gamma$-mercaptopropylmethyldiethyoxysilane); epoxy group-containing silanes (e.g. $\gamma$-glycidoxypropylmethyldimethoxysilane, $\gamma$-glycidoxypropylmethyldiethoxysilane and $\beta$-(3,4-epoxycyclohexyl)ethylmethyldimethoxysilane); carboxysilanes (e.g. $\beta$-carboxyethylmethyldiethoxysilane, $\beta$-carboxyethylphenylbis(2-methoxyethoxy)silane and N-$\beta$-(N-carboxymethylaminoethyl)-$\gamma$-aminopropylmethyldimethoxysilane); and the like. The silane compounds may be used independently or as a mixture of two or more of them.

The amount of the silicon-containing compound (E) is from 0.1 to 20 parts by weight, preferably from 0.2 to 10 parts by weight per 100 parts of total weight of the organic rubbery polymer (A) and the epoxy resin (B).

When the amount of the silicon-containing compound (E) is less than the above lower limit, the cured product has insufficient shear strength. The use of the silicon-containing compound (E) in an amount larger than the above upper limit is not economical.

When the silicon-containing compound (E) is used in the composition in which the weight ratio of the organic rubbery polymer (A) to the epoxy resin (B) is in the range from 100:70 to 100:500, the cured product has excellent shear strength.

Since the silicon-containing reactive group of the organic rubbery polymer (A) and the silicon-containing reactive group of the epoxy resin (B) have substantially the same reactivity, the cured product may have a structure suitable for exhibiting the preferable properties. If the compound (E) has the silicon-containing reactive group to the silicon atom of which three alkoxy groups are attached, the cured product does not have such preferable properties.

In addition to the essential components (A), (B), (C), (D) and (E), the curable resin composition of the present invention may optionally contain other conventionally used additives such as a filler, a plasticizer, an anti-aging agent, an ultraviolet light absorbing agent, a lubricant, a pigment, a foaming agent and a silane coupling agent.

Specific examples of the filler are wood meal, pulp, cotton chip, asbestos, glass fiber, carbon fiber, mica, walnut shell flour, rice hull flour, graphite, diatomaceous earth, china clay, fumed silica, precipitated silica, silicic anhydride, carbon black, calcium carbonate, clay, talc, titanium oxide, magnesium carbonate, quartz powder, aluminum powder, flint powder, zinc powder and mixtures thereof.

The curable composition of the present invention can be prepared by a per se conventional method and can be cured at room temperature, although the curing rate is increased at an elevated temperature.

The curable composition of the present invention is preferably used as an adhesive for adhering metals (e.g. iron, copper and aluminum), synthetic resins (e.g. polyethylene, polypropylene, polyvinyl chloride, ABS resins, fluororesins, silicone resins, bakelite, polystyrene resins, methacrylic resins, polycarbonate, polyacetal, polyamide such as 6-nylon, polyether ether ketone, polyether sulfone, polysulfone, polyamideimide, polyethylene terephthalate, polybutylene terephthalate, polyphenylene sulfide and modified polyphenylene oxide), rubbers (e.g. natural rubbers, butadiene rubbers, styrene-butadiene rubbers, butyl rubbers, NBR, silicone rubbers, EPDM, acrylic rubbers and fluororubbers), woods, glass, porcelains, ceramics, stones, hard boards, slates, calcium silicate boards, mortar and concrete) and the like. Examples of specific application are adhesion of light metal window frames or doors, adhesion of a substrate for printed circuits and a copper foil, adhesion of abrasives on a water-resistant paper, in-situ adhesion of prefabricated concrete blocks and exterior decoration of constructions or buildings with pretty pebbles or stones.

Since the curable composition of the present invention provides the cured product with high modulus, it can be used for applications where the high modulus of the cured produced is required.

## PREFERRED EMBODIMENTS OF THE INVENTION

The present invention will be illustrated by following Examples, in which "parts" are by weight unless otherwise indicated.

### Preparation Example 1

Polypropylene glycol having the number average molecular weight of 2500 (90 parts) and polypropylene triol having the number average molecular weight of 3000 (10 parts) were chain extended with methylene chloride according to the method described in U.S. Patent No. 4,657,986 and molecular ends were capped with allyl chloride to obtain polypropylene oxide 99 % of the terminal groups of which were capped with allyl ether groups and which had the number average molecular weight of 8000.

The resulting polypropylene oxide (800 g) and then methyldimethoxysilane (20 g) were charged in an autoclave equipped with a stirrer. After the addition of a solution of chloroplatinic acid (8.9 g of $H_2PtCl_6.6H_2O$) in 18 ml of isopropanol and 160 ml of tetrahydrofurane (0.40 ml), the reaction was continued at 80 °C for 6 hours while stirring.

An amount of the unreacted hydrogenated silicon-containing groups in the reaction mixture was monitored by IR spectrum analysis to find that substantially no such group remained. According to determination of the silicon-containing group by NMR, it was confirmed that polypropylene oxide had, at the chain end, about 1.75 groups of the formula:

$(CH_3O)_2Si(CH_3)CH_2CH_2CH_2O$-

in a molecule on the average.

### Preparation Example 2

Polypropylene glycol having the number average molecular weight of 2000 was chain extended with methylene chloride and capped with allyl chloride to obtain polypropylene oxide 95 % of the terminal groups of which were capped with allyl ether groups and which had the number average molecular weight of 5000.

The resulting polypropylene (500 g) and then methyldiethoxysilane (27 g) were charged in the autoclave equipped with stirrer. After the addition of the solution of chloroplatinic acid having the same composition as in Preparation Example 1 (0.40 ml), the reaction was continued at 90 °C for 3 hours.

After removing the excessive methyldiethoxysilane under reduced pressure, an amount of the silicon-containing groups was measured by NMR to confirm that polypropylene oxide had, at the chain end, about 1.75 groups of the formula:

$(CH_3CH_2O)_2Si(CH_3)CH_2CH_2CH_2O$-

in a molecule on the average.

### Preparation Example 3

Polypropylene glycol having the number average molecular weight of 2000 was chain extended with methylene chloride to obtain polypropylene oxide having the number average molecular weight of 6000.

The resulting polypropylene glycol (600 g), γ-isocyanatepropylmethyldiethoxysilane (43 g) and dibutyltin dilaurate (0.2 g) were charged in the autoclave equipped with stirrer and reacted at 100° C for 5 hours to obtain polypropylene oxide having the number average molecular weight of about 6400 and, at the chain end, about 2 groups of the formula:

$(CH_3CH_2O)_2Si(CH_3)CH_2CH_2CH_2NHCOO-$

in a molecule on the average.

## Preparation Example 4

Butyl acrylate (80 g), stearyl methacrylate (20 g), γ-methacryloyloxypropylmethyldimethoxysilane (2.2 g), γ-mercaptopropylmethyldimethoxysilane (1.8 g) and 2,2′-azobisisobutyronitrile (0.5 g) were homogeneously mixed. Then, the mixture (25 g) was charged in a four-necked 200 ml flask equipped with a stirrer and a condenser and heated to 80° C on an oil bath while introducing nitrogen gas. Within several minutes, the polymerization was initiated with generating heat. After the heat generation calmed, the rest of the mixture was dropwise added over 3 hours to proceed poly merization. After 15 minutes and 30 minutes from the completion of addition of the mixture, azobisisobutyronitrile (each 0.15 g) was added. After the addition of the latter portion of azobisisobutyronitrile, stirring was continued for 30 minutes to complete the polymerization.

The resulting liquid polymer was analyzed by gas permeation chromatograph (GPC) to find that the polymer had the number average molecular weight of about 10,000.

## Examples 1 and 2 and Comparative Examples 1 and 2

Bisphenol A type epoxy resin (Epikote 828 (trade name) manufactured by Yuka Shell Epoxy Co., Ltd) (75 parts), the polymer prepared in Preparation Example 1 (100 parts), 2,2′-methylene-bis(4-methyl-6-tert.-butylphenol) (1 part), 2,4,6-tris(dimethylaminomethyl)phenol (DMP-30) (7.5 parts), N-β-(aminoethyl)-γ-aminopropylmethyldimethoxysilane (1 part) and the organic tin compound #918 (manufactured by Sankyo Organic Synthesis Co., Ltd.) (1 part) were thoroughly mixed and carefully poured in a polyethylene made frame so as to avoid the formation of bubbles. Then, the mixture was cured at 23° C for 2 days and post-cured at 50° C for 3 days to produce a sheet of the cured product having the thickness of 2 mm.

From the sheet, a No. 3 dumbbell was punched according to JIS (Japanese Industrial Standard) K 6301. Modulus at 100 % elongation ($M_{100}$), Tensile strength at break ($T_B$) and elongation at break ($E_B$) were measured at the pulling rate of 500 mm/min. The results are shown in Table 2.

In Example 2, 3 parts of N-(β-aminoethyl)-γ-aminopropylmethyldimethoxysilane was used instead of 1 part, and in Comparative Examples 1 and 2, in place of the aminosilane having two alkoxy groups, N-(β-aminoethyl)-γ-aminopropyltrimethyoxysilane which had three alkoxy groups was used in an amount of 1 part and 3 parts, respectively. The results are shown in Table 2.

With each of the compositions prepared in Examples 1 and 2 and Comparative Examples 1 and 2, its performance as an adhesive was examined according to JIS K 6850 (tensile shear strength) and JIS K 6854 (T-shape peeling strength).

### Tensile shear strength

On an aluminum plate (according to JIS H 4000. A-1050P. 100 mm x 25 mm x 2.0 mm), the composition was coated. A pair of the same coated aluminum plates were laminated with facing the coated surfaces to each other and pressed with a hand. The laminated plates were kept at 23° C for 2 days and aged at 50° C for 3 days and peeled off at the pulling rate of 50 mm/min. to measure the tensile shear strength.

### T-shape peeling strength

On an aluminum plate (according to JIS H 4000. A-1050P. 200 mm x 25 mm x 0.1 mm), the

composition was coated in a thickness of about 0.5 mm. A pair of the same coated aluminum plates were laminated with facing the coated surfaces to each other and pressed five times by moving a hand roller with 5 kg of load along the length in one direction. The laminated plates were kept at 23 °C for 2 days and aged at 50 °C for 3 days and peeled off at the pulling rate of 200 mm/min. to measure the T-shape peeling strength.

The results are also shown in Table 2.

Table 2

| Example No. | 1 | 2 | C. 1 | C. 2 |
|---|---|---|---|---|
| Aminosilane*1) (parts) | AAMDMS 1 | AAMDMS 3 | AATMS 1 | AATMS 3 |
| $M_{100}$ (kg/cm$^2$) | 54 | 78 | 23 | 25 |
| $T_B$ (kg/cm$^2$) | 90 | 85 | 82 | 79 |
| $E_B$ (%) | 200 | 120 | 270 | 240 |
| Tensile shear strength (kg/cm$^2$) | 112 | 125 | 83 | 78 |
| T-shape peeling strength (kg/cm$^2$) | | | | |

Notes: *1) AAMDMS: N-β-(Aminoethyl)-γ-aminopropylmethyldimethoxysilane.
AATMS: N-β-(Aminoethyl)-γ-aminopropyltrimethoxysilane.

The results in Table 2 indicate that the use of the aminosilane having two alkoxy groups provides the cured product with high modulus and increases the tensile shear strength when the composition is used as the adhesive.

Examples 3 to 5 and Comparative Example 3

In the same manner as in Example 1 but changing the amounts of Epikote 828 and DMP-30, the compositions were prepared and their tensile properties were evaluated.

The results are shown in Table 3.

Table 3

| Example No. | 3 | 4 | 5 | C. 3 |
|---|---|---|---|---|
| Epikote (parts) | 100 | 150 | 200 | 50 |
| DMP-30 (parts) | 10 | 15 | 20 | 5 |
| $M_{50}$ (kg/cm$^2$) | 56 | 69 | --- | 12 |
| $T_B$ (kg/cm$^2$) | 87 | 72 | 67 | 66 |
| $E_B$ (%) | 110 | 56 | 33 | 280 |

When the amount of Epikote 828 was small, the high modulus of the cured product was not achieved. When Epikote 828 was used in a large amount, the high modulus of the cured product was achieved.

Examples 6 to 9

In the same manner as in Example 1 but using the silicon-containing compounds shown in Table 4 in place of N-β-(aminoethyl)-γ-aminopropylmethyldimethoxysilane, the compositions were prepared and their performances as the adhesives were evaluated in terms of the tensile shear strength and the T-shape

peeling strength.

The results are shown in Table 4. With all the compositions of Examples 6 to 9, high tensile shear strength was achieved.

Table 4

| Example No. | 6 | 7 | 8 | 9 |
|---|---|---|---|---|
| Silicon-cont. compound*1) (parts) | APMDES 1 | APMDMES 1 | MPMDMS 1 | GPMDMS 1 |
| Tensile shear strength (kg/cm$^2$) | 123 | 115 | 103 | 109 |
| T-shape peeling strength (kg/cm$^2$) | 8.4 | 8.7 | 7.6 | 8.1 |

Note: *1) APMDES: γ-Aminopropylmethyldiethoxysilane.
APMDMES: γ-Aminopropylmethyldi(2-methoxyethoxy)silane.
MPMDMS: γ-Mercaptopropylmethyldimethoxysilane.
GPMDMS: γ-Glycidoxypropylmethyldimethoxysilane.

Examples 10-12

In the same manner as in Example 1 but using each of the polymers prepared in Preparation Examples 2-4 in place of that prepared in Preparation Example 1, the composition was prepared and their tensile shear strength was measured.

The results are shown in Table 5.

Table 5

| Example No. | 10 | 11 | 12 |
|---|---|---|---|
| Polymer (A) (parts) | Prep. Ex. 2 100 | Prep. Ex. 3 100 | Prep. Ex. 4 40 |
| | | | Prep. Ex. 1 60 |
| Tensile shear strength (kg/cm$^2$) | 123 | 128 | 119 |

## Claims

1. A curable resin composition comprising

(A) 100 parts by weight of an organic rubbery polymer having a cross-linkable group of the formula:

$$\begin{array}{c} R^1 \\ | \\ -Si(OR^2)_2 \end{array}$$

wherein $R^1$ and $R^2$ are the same or different and each a substituted or unsubstituted monovalent hydrocarbon group having 1 to 20 carbon atoms,

(B) 70 to 500 parts by weight of an epoxy resin,

(C) 0.1 to 20 parts by weight of a silanol condensation catalyst per 100 parts by weight of the organic rubbery polymer (A),

(D) 0.1 to 300 parts by weight of a curing agent for the epoxy resin per 100 parts by weight of the epoxy resin (B), and

(E) a silicon-containing compound having a cross-linkable group of the formula:

$$-\overset{\displaystyle R^1}{\overset{|}{Si}}(OR^2)_2$$

wherein $R^1$ and $R^2$ are the same as defined and a functional group reactive with an epoxy group, wherein a weight ratio of the total weight of the organic rubbery polymer (A) and the epoxy resin (B) to the weight of the silicon-containing compound (E) is from 100:0.1 to 100:20.

2. The curable resin composition according to claim 1, wherein the organic rubbery polymer (A) has the backbone consisting of a polyether which comprises repeating units of the formula:

$-R^3-O-$

wherein $R^3$ is a divalent alkylene group having 2 to 4 carbon atoms.

3. The curable resin composition according to claim 2, wherein the polyether is polypropylene oxide.

4. The curable resin composition according to claim 1, wherein the backbone of the organic rubbery polymer comprises polyacrylate.

5. The curable resin composition according to claim 4, wherein the polyacrylate is a polymer comprising butyl acrylate.

6. The curable resin composition according to claim 1, wherein the $R^1$ group in the cross-linkable group of the organic rubbery polymer (A) is an alkyl group.

7. The curable resin composition according to claim 1, wherein the $R^2$ group in the cross-likable group of the organic rubbery' polymer (A) is an alkyl group.

8. The curable resin composition according to claim 7, wherein the alkyl group is a methyl group.

9. The curable resin composition according to claim 1, wherein the cross-linkable group of the organic rubbery polymer (A) is attached to the chain end.

10. The curable resin composition according to claim 1, wherein the functional group of the silicon-containing compound (E) is an amino group.

11. The curable resin composition according to claim 1, wherein the silicon-containing compound (E) is at least one selected from the group consisting of $\gamma$-aminopropylmethyldimethoxysilane and N-$\beta$-(aminoethyl)-$\gamma$-aminopropylmethyldimethoxysilane.